# EUROPÄISCHE PATENTSCHRIFT

(11) **EP 3 074 836 B1**
(45) Veröffentlichungstag und Bekanntmachung des Hinweises auf die Patenterteilung: **28.08.2019**
(21) Anmeldenummer: 14809314.9
(22) Anmeldetag: 27.11.2014
(51) Int. Cl.: G05G 5/00, G05G 9/047, F16H 59/10, F16H 59/02

(54) **STELLGLIED, INSBESONDERE FÜR EIN KRAFTFAHRZEUG**
ACTUATOR, IN PARTICULAR FOR A MOTOR VEHICLE
ORGANE DE RÉGLAGE, EN PARTICULIER POUR VÉHICULE AUTOMOBILE

(30) Priorität: 29.11.2013 DE 102013017969; 29.11.2013 DE 102013017968; 29.11.2013 DE 102013017966
(43) Veröffentlichungstag der Anmeldung: 05.10.2016
(73) Patentinhaber: Marquardt GmbH, 78604 Rietheim-Weilheim (DE)
(72) Erfinder: BUSCHLE, Roland, 78570 Mühlheim (DE); BERCHTOLD, Rainer, 78532 Tuttlingen-Nendingen (DE); MASA, Robert, 78628 Rottweil (DE)
(74) Vertreter: Otten, Roth, Dobler & Partner mbB Patentanwälte
(86) Internationale Anmeldenummer: PCT/EP2014/075818
(87) Internationale Veröffentlichungsnummer: WO 2015/078970

(56) Entgegenhaltungen:
- WO-A1-91/15864
- DE-A1- 3 319 417
- DE-A1-102011 087 162
- FR-A1- 2 737 160
- JP-A- 2007 030 762
- JP-A- 2008 062 664
- JP-A- 2008 155 727
- US-A1- 2008 006 113
- US-A1- 2008 197 004
- US-A1- 2011 183 759
- US-B1- 6 415 677

## Beschreibung

Die Erfindung betrifft ein Stellglied nach dem Oberbegriff des Patentanspruchs 1.

Stellglieder, wie in der Art eines Joystick- und/oder Cursor-Schalters ausgebildete elektrische und/oder elektronische Schaltvorrichtungen, dienen zur manuellen Ansteuerung von Funktionen in einem Kraftfahrzeug. Unter anderem werden solche Schaltvorrichtungen zur Eingabe von Daten für ein elektrisches Gerät durch einen Benutzer verwendet, beispielsweise bei Autoradios, Navigationsgeräten, Bordcomputer o. dgl. Geräten im Kraftfahrzeug. Insbesondere lässt sich ein solches Stellglied auch als elektronischer Gangwahlschalter für ein durch Shift-by-Wire gesteuertes Getriebe im Kraftfahrzeug verwenden.

Ein solches, aus der US 2008/006113 A1 bekanntes Stellglied weist eine Handhabe auf, die beispielsweise in der Art eines Wählhebels ausgebildet sein kann. Die Handhabe ist an einem Träger bewegbar gelagert, derart dass die Handhabe in zwei verschiedenen Richtungen manuell aus einer neutralen Stellung in Verstellpositionen verstellbar ist. Und zwar ist die Handhabe in zumindest jeweils eine der jeweiligen Richtung zugeordnete Verstellposition verschwenkbar. Das Stellglied weist weiter ein Mittel zur Erfassung der Verstellpositionen auf. Das Mittel zur Erfassung der Verstellpositionen umfasst einen Code-Träger, der eine Codierung für die Verstellpositionen aufweist, sowie einen die Codierung ermittelnden Sensor. Insbesondere handelt es sich dabei um eine eindeutige Codierung für die Verstellpositionen. Dadurch sind sämtliche Verstellpositionen mittels des einen einzigen Code-Trägers erfassbar. Der Code-Träger steht derart in Zusammenwirkung mit der Handhabe, dass der Code-Träger aufgrund der Schwenkbewegung der Handhabe in zwei Richtungen linearbeweglich ist. Das Mittel zur Erfassung der Verstellpositionen ist bei dem bekannten Stellglied aufwendig ausgestaltet.

Weiter ist ein Stellglied in der Art eines Joystick-Schalters in der US 2011/183759 A1 beschrieben. Schließlich sind als Gangwahlschalter für Kraftfahrzeuge dienende Stellglieder in der US 6 415 677 B1 und der JP 2008-62664 A gezeigt.

Der Erfindung liegt die Aufgabe zugrunde, das Stellglied derart weiterzuentwickeln, dass das Mittel zur Erfassung der Verstellpositionen einfacher ausgestaltet ist. Insbesondere soll das Mittel zur Erfassung der Verstellpositionen im Hinblick auf dessen Kosten und Robustheit weiter verbessert werden.

Diese Aufgabe wird bei einem gattungsgemäßen Stellglied durch die kennzeichnenden Merkmale des Anspruchs 1 gelöst.

Beim erfindungsgemäßen Stellglied ist in einfacher Art und Weise die Zusammenwirkung der Handhabe mit dem Code-Träger mittels eines in ein Langloch eingreifenden Stiftes bewirkt. Dabei ist ein Stift an der Handhabe angeordnet. Dieser Stift greift in ein in die eine Richtung der Linearbewegung verlaufendes Langloch des Code-Trägers ein. Wenigstens ein weiterer Stift ist am Träger angeordnet. Dieser Stift greift in ein in die weitere Richtung der Linearbewegung verlaufendes Langloch des Code-Trägers ein. Mit Hilfe einer solchen Anordnung wird folglich die Schwenkbewegung der Handhabe in eine korrespondierende Linearbewegung des Code-Trägers umgesetzt, so dass eine einfache und funktionssichere Detektierung der Verstellpositionen mittels des Sensors geschaffen ist. Das erfindungsgemäße Stellglied zeichnet sich durch eine hohe Funktionssicherheit aus. Weitere Ausgestaltungen der Erfindung sind Gegenstand der Unteransprüche.

Zwecks weiterer Steigerung der Ergonomie für die Bedienung des Stellglieds durch den Benutzer handelt es sich bei der Verstellbewegung um eine Schwenkbewegung der Handhabe, womit es sich bevorzugterweise bei der Handhabe um einen schwenkbaren Wählhebel handelt. Die Handhabe kann um eine erste und eine zweite Schwenkachse in eine erste und eine zweite Schwenkrichtung verstellbar sein, wobei die beiden Schwenkrichtungen in etwa senkrecht aufeinander stehen können. In kompakter Ausgestaltung kann der Träger für die Handhabe in der Art eines Kardangelenks und/oder eines Kreuzgelenks ausgebildet sein.

Zweckmäßigerweise können bei Verstellung der Handhabe der Code-Träger sowie der Sensor relativ zueinander bewegbar sein. In einfacher Ausgestaltung können der Code-Träger und/oder der Sensor derart an der Handhabe angelenkt sein, dass der Code-Träger und/oder der Sensor mittels der Handhabe korrespondierend zur Verstellung der Handhabe bewegbar sind.

In kompakter Ausgestaltung können die beiden Richtungen der Linearbewegung des Code-Trägers senkrecht aufeinander stehen.

Erfindungsgemäß ist der Stift an der Handhabe an einem Hebelarm der Handhabe angeordnet. Der weitere Stift am Träger kann an einer Verlängerung am Träger angeordnet sein.

In kostengünstiger Art und Weise kann der Code-Träger eine magnetische Code-Platte umfassen sowie der Sensor aus einem Magnetsensor bestehen. Insbesondere kann es sich bei dem Magnetsensor um einen Hallsensor, einen magnetisch-resistiven Sensor, einen induktiven Sensor o. dgl. handeln. Die Codierung für die Verstellpositionen kann wiederum aus einer der jeweiligen Verstellposition eindeutig zugeordneten Magnetisierung der Code-Platte bestehen.

Zwecks kompakter Ausgestaltung kann der Code-Träger eine Leiterplatte umfassen. Zweckmäßigerweise kann die Leiterplatte die Elektronik für das Stellglied, die beispielsweise zur Auswertung der Signale des Sensors dient, aufnehmen. Der einfachen Montage halber kann die magnetische Code-Platte auf der Leiterplatte angeordnet sein.

In einfacher Art und Weise kann die magnetische Code-Platte mittels Distanzstücke in der Art von Abstandshaltern auf der Leiterplatte befestigt sein. Die Distanzstücke können als Metalldistanzen, beispielsweise durch eine dementsprechende Beschichtung ausgebildet sein. Dadurch kann dann die Code-Platte magnetisch, d.h. mittels Magnetkraft, an der Leiterplatte befestigt sein. Die Metalldistanzen können in fertigungstechnisch einfacher Art mittels Löten im SMD(Surface Mounted Device)-Verfahren auf die Leiterplatte aufgebracht sein.

Für eine besonders bevorzugte Ausgestaltung der Erfindung ist nachfolgendes festzustellen.

Bei einer Shift-by-Wire-Schaltbox soll das Signalerfassungssystem hinsichtlich Kosten und Robustheit verbessert werden.

Hierzu wird die Signalerfassung nicht mehr wie bisher in verschiedene Bewegungsrichtungen aufgeteilt und mittels einzelnen Metallplatten erfasst sondern in ein Codiersystem zusammengefasst und dieses ausgewertet. Die Lagerung der magnetischen Codeplatte erfolgt mittels beschichteten Metalldistanzen die im SMD-Verfahren auf die Leiterplatte aufgebracht werden.

Geschaffen ist dadurch ein Magnetplattensystem zur Erfassung von Signalen in zwei Raumrichtungen einschließlich der Lagerung des Magnetplattensystems, also inclusive der magnetischen Lagerung.

Die mit der Erfindung erzielten Vorteile bestehen insbesondere darin, dass die Gesamtkosten für das Stellglied durch die Reduzierungen an Teilen bei der Signalerfassung deutlich gesenkt werden. Zudem wird die Genauigkeit des Systems durch die magnetische Lagerung der Platten verbessert. Bisher benötigte Fertigungsschritte, wie Fetten der Führungen zur Vermeidung von Geräuschbildung bei der Verstellung der Handhabe, können entfallen.

Bei einem Stellglied in weiterer Ausgestaltung ist die Handhabe an einem Träger bewegbar gelagert, derart dass die Handhabe in wenigstens eine Richtung manuell aus einer neutralen Stellung in eine Verstellposition verstellbar ist. Die Verstellbewegung ist als Rastbewegung und/oder die Verstellposition ist als Raststellung ausgebildet, derart dass eine Rastkraft während der Verstellbewegung und/oder in der Verstellposition auf die Handhabe einwirkt. Bei einem solchen Stellglied kann der auf den Benutzer einwirkende Kraftverlauf für die Verstellbewegung und/oder für die Verstellung in die Raststellung ungleichmäßig sein. Das Stellglied soll daher derart weiterentwickelt werden, dass der Kraftverlauf für die Verstellbewegung der Handhabe weitgehend gleichmäßig ist. Insbesondere soll die Bedienhaptik der Handhabe für den Benutzer verbessert werden.

Bei dem weiterentwickelten Stellglied ist die Rastkraft durch ein gefedertes Druckstück erzeugbar. Aufgrund der während der Verstellbewegung über das Druckstück auf die Handhabe einwirkenden Federkraft ist der Kraftverlauf für die Verstellbewegung vorteilhafterweise im wesentlichen gleichmäßig.

Zur Erweiterung der Funktionalität kann die Handhabe aus einer neutralen Stellung in zwei verschiedene Richtungen in zumindest jeweils eine, der jeweiligen Richtung zugeordneten Verstellposition verstellbar ausgestaltet sein. Desweiteren kann ein Mittel zur Erfassung der Verstellpositionen vorgesehen sein.

Zwecks weiterer Steigerung der Ergonomie für die Bedienung des Stellglieds durch den Benutzer kann es sich bei der Verstellbewegung um eine Schwenkbewegung der Handhabe handeln, womit es sich bevorzugterweise bei der Handhabe um einen schwenkbaren Wählhebel handelt. Die Handhabe kann um eine erste und eine zweite Schwenkachse in eine erste und eine zweite Schwenkrichtung verstellbar sein, wobei die beiden Schwenkrichtungen in etwa senkrecht aufeinander stehen können. In kompakter Ausgestaltung kann der Träger für die Handhabe in der Art eines Kardangelenks und/oder eines Kreuzgelenks ausgebildet sein.

In einfacher sowie kompakter Ausgestaltung kann das gefederte Druckstück mit einer Kulisse in Zusammenwirkung bringbar sein. Insbesondere kann dieses Zusammenwirken zur Erzeugung einer Haptik für die Verstellung der Handhabe dienen. In einfacher Art und Weise kann das gefederte Druckstück mittels eines bewegbaren Adapters zur Zusammenwirkung in die Kulisse gedrückt werden.

Zur weiteren Steigerung der Funktionalität des Stellgliedes kann die Handhabe für die Verstellung sperrbar sowie zur Verstellung durch den Benutzer freigebbar sein. In einfacher Art und Weise kann die Sperrung und/oder die Freigabe der Handhabe mittels einer am Adapter angeformten Geometrie erfolgen. In kompakter Ausgestaltung kann hierfür ein ansteuerbares Sperrmittel mit der Geometrie in und/oder außer Wirkverbindung bringbar sein.

Desweiteren kann der Adapter mittels eines Aktors zur Einwirkung auf das Druckstück bewegbar sein, womit beispielsweise die Haptik für das Stellglied einstellbar ist und/oder die Verstellbewegung für die Handhabe auf eine Bewegungsgasse einstellbar ist. Bei dem Aktor kann es sich um einen Elektromotor, einen Elektromagneten o. dgl. handeln.

Für eine besonders bevorzugte Ausgestaltung der Erfindung ist nachfolgendes festzustellen.

Bei einer Shift-by-Wire-Schaltbox soll das bisherige Haftsystem der manuellen Schaltgasse für den Wählhebel hinsichtlich der Bedienhaptik verbessert werden. Insbesondere soll ein gleichmäßiger Kraftverlauf für die jeweilige Schwenkbewegung des Wählhebels gegeben sein. Ferner soll die Sperrfunktion der manuellen Gasse, die bisher mit einem separaten Sperrmagneten realisiert wird, in den gleichen Aktor integriert werden.

Die Rastung in der manuellen Schaltgasse wird nicht wie bisher durch den magnetischen Schluss von Ankerplatte und Haftsystem sondern durch ein gefedertes Druckstück erzeugt. Dieses gefederte Druckstück wird zur Erzeugung der Haptik mittels eines Adapterteils in die Kulisse gedrückt. Gleichzeitig erfolgt durch eine am Adapter angeformte Geometrie die Entriegelung der Gassensperre. Die lineare Bewegung des Adapters erfolgt durch einen Aktor, beispielsweise einen Elektromagneten oder einen Elektromotor. Bei nicht bestromtem Aktor hebt das gefederte Druckstück aus der Kulisse ab. Das Kreuzgelenk schwenkt dadurch in die neutrale Stellung, also in eine senkrechte Position, und die Sperre verriegelt das Gesamtsystem.

Geschaffen ist somit ein mechatronisches Aktorsystem zur Rastierung und/oder Rückstellung und/oder Sperrung eines Betätigungselementes bei Shift-By-Wire-Systemen.

Die mit der Erfindung erzielten Vorteile bestehen insbesondere darin, dass die Rastfunktion gegenüber der bisherigen Rastierung, die durch ein Haftsystem erzeugt ist, mit einer deutlich verbesserten Haptik versehen ist. Der Aufbau der Einheit wird kostengünstiger, da die Systemparameter aufgeweitet werden können und nicht wie bisher eng toleriert werden müssen. Die Gesamteinheit wird außerdem dadurch deutlich günstiger, da nur noch ein Aktor benötigt wird.

Bei einem Stellglied in weiterer Ausgestaltung ist die Handhabe an einem Träger bewegbar gelagert, derart dass die Handhabe manuell von einem Benutzer verstellbar ist. Dabei kann die Handhabe für die Bedienung sperrbar sowie zur Bedienung durch den Benutzer freigebbar ausgestaltet sein. Bisher erfolgt die Freigabe der Handhabe mittels Betätigung einer Taste durch den Benutzer, der sogenannten "Unlock"-Taste, wobei Verständnisschwierigkeiten im Handhabungsablauf für den Benutzer bei der Bedienung dieser Unlock-Taste beobachtet werden.

Das Stellglied soll daher derart weiterentwickelt werden, dass die Bedienung der Handhabe, insbesondere im Hinblick auf deren Freigabe, verbessert ist.

Bei dem weiterentwickelten Stellglied ist ein Sensor zur Zusammenwirkung mit der Handhabe vorgesehen, derart dass durch Annäherung an die Handhabe und/oder Berühren, insbesondere Umgreifen, der Handhabe durch den Benutzer, insbesondere durch dessen Hand, der Bedienungswunsch des Benutzers erkennbar sowie die Handhabe zur Bedienung freigebbar ist und/oder eine sonstige Funktionalität im Kraftfahrzeug auslösbar ist. Vorteilhafterweise erkennt ein solches Stellglied den Bedienungswunsch des Benutzers ohne dass zusätzliche Betätigungen des Benutzers erforderlich sind, womit das Stellglied intuitiv vom Benutzer bedienbar ist.

Zur Erweiterung der Funktionalität kann die Handhabe aus einer neutralen Stellung in zwei verschiedene Richtungen in zumindest jeweils eine, der jeweiligen Richtung zugeordneten Verstellposition verstellbar ausgestaltet sein. Desweiteren kann ein Mittel zur Erfassung der Verstellpositionen vorgesehen sein.

Zwecks weiterer Steigerung der Ergonomie für die Bedienung des Stellglieds durch den Benutzer kann es sich bei der Verstellbewegung um eine Schwenkbewegung der Handhabe handeln, womit es sich bevorzugterweise bei der Handhabe um einen schwenkbaren Wählhebel handelt. Die Handhabe kann um eine erste und eine zweite Schwenkachse in eine erste und eine zweite Schwenkrichtung verstellbar sein, wobei die beiden Schwenkrichtungen in etwa senkrecht aufeinander stehen können. In kompakter Ausgestaltung kann der Träger für die Handhabe in der Art eines Kardangelenks und/oder eines Kreuzgelenks ausgebildet sein.

In einfacher sowie kostengünstiger Ausgestaltung kann es sich bei dem Sensor um einen kapazitiven Sensor handeln. Ein derartiger Sensor detektiert die Veränderung des elektrischen Feldes in der Umgebung der Handhabe aufgrund der Einwirkung des Benutzers, beispielsweise durch dessen Hand, um daraus wiederum den Bedienungswunsch des Benutzers abzuleiten. Selbstverständlich sind auch sonstige Sensoren hierfür verwendbar. So kann es sich bei dem Sensor auch um einen mittels optischer Strahlung arbeitenden optischen Sensor oder einen induktiven Sensor handeln. Als optische Strahlung erscheint insbesondere Infrarot(IR)-Strahlung vorteilhaft, da diese für das Auge des Benutzers nicht sichtbar ist.

In einer weiteren zweckmäßigen Ausgestaltung kann ein Sperrmittel für die Handhabe vorgesehen sein. Mit Hilfe des Sperrmittels ist somit die manuelle Verstellung der Handhabe sperrbar sowie freigebbar. Der Sensor kann bei Erkennung des Bedienungswunsches des Benutzers ein Sensorsignal erzeugen. Das Sensorsignal kann dann zur Ansteuerung des Sperrmittels für die Freigabe der Handhabe dienen.

Für eine besonders bevorzugte Ausgestaltung der Erfindung ist nachfolgendes festzustellen.

Bei der Bedienung der Unlocktaste bei Shift-by-Wire-Systemen im Fahrzeug, die bisher an der Handhabe als ein elektrischer Schalter mit Tasten-Funktion angeordnet ist, zeigen sich immer wieder Verständnisschwierigkeiten im Handhabungsablauf. Auch eine Beschriftung der Taste zeigt hinsichtlich der Bedienverständlichkeit keine deutliche Verbesserung.

Zur Verbesserung dieser Problematik ist vorgeschlagen, dass die Unlock-Tastenfunktion mittels eines kapazitiven Sensors überwacht und der Fahrerwunsch durch Umgreifen des Gangwahlschalters gedeutet wird. Die Bediensicherheit ist durch das Erkennungsfeld unterhalb der bisherigen Taste eindeutig definiert. Ein Drücken der Taste entfällt, der Fahrerwunsch "0" oder "R" für das Automatikgetriebe wird bei Betätigung des Wählhebels und den entsprechenden Fahrzeugzuständen direkt umgesetzt.

Geschaffen ist somit durch die Erfindung eine insbesondere kapazitive Signalerfassung für Shift-by-Wire-Systemen.

Die mit der Erfindung erzielten Vorteile bestehen insbesondere darin, dass durch die Erfindung die Bedienung des Gesamtsystems deutlich einfacher und komfortabler für den Benutzer ist. Zudem zeigt diese Lösung ein deutliches Kosteneinsparpotential gegenüber der bisherigen Tastenlösung, da insoweit auf einen elektrischen Schalter an der Handhabe verzichtet werden kann.

Ausführungsbeispiele der Erfindung mit verschiedenen Weiterbildungen und Ausgestaltungen sind in den Zeichnungen dargestellt und werden im folgenden näher beschrieben. Es zeigen
- Fig. 1: ein Stellglied in schematischer Ansicht,
- Fig. 2: ein Teil des Stellgliedes aus Fig. 1 in perspektivischer Ansicht,
- Fig. 3: die Seitenansicht des Teiles des Stellglieds aus Fig. 2,
- Fig. 4: eine Detailansicht des Code-Trägers aus Fig. 3,
- Fig. 5: ein Stellglied gemäß einer weiteren Ausgestaltung in schematischer Darstellung und
- Fig. 6: ein Stellglied gemäß einer nochmals weiteren Ausgestaltung in schematischer Darstellung.

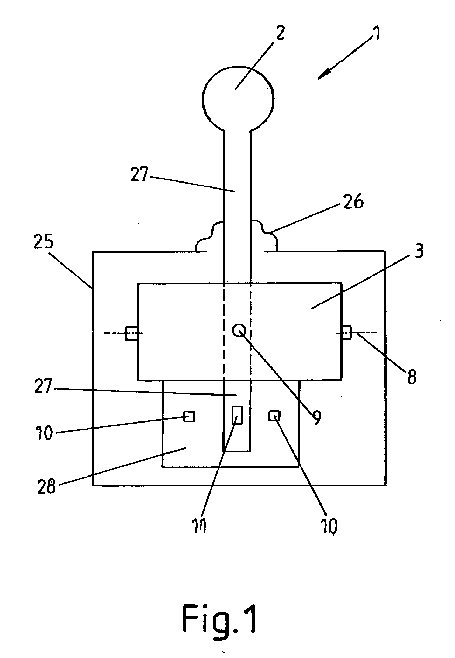

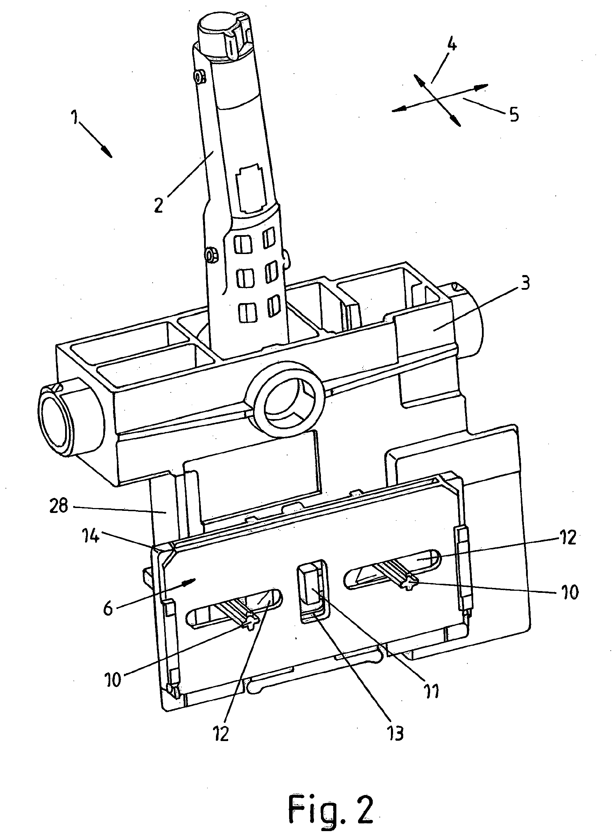

In Fig. 1 ist ein Stellglied 1 zu sehen, das zur manuellen Ansteuerung von Funktionen in einem Kraftfahrzeug dient und insbesondere als Gangwahlschalter für eine Shift-by-Wire-Schaltvorrichtung verwendet wird. Das Stellglied 1 ist mit einer bewegbaren Handhabe 2 in der Art eines Wählhebels versehen, wobei die Handhabe 2 mit einer beweglichen Manschette 26 abgedichtet aus einem Gehäuse 25 des Stellgliedes 1 herausragt. Die Handhabe 2 ist beweglich an einem im Gehäuse 25 befindlichen Träger 3 derart gelagert, dass die Handhabe 2 in wenigstens eine Richtung, bevorzugterweise in zwei verschiedenen Richtungen 4, 5 (siehe Fig. 2) aus einer neutralen Stellung in zumindest jeweils eine der jeweiligen Richtung 4, 5 zugeordnete Verstellposition verstellbar ist. Dadurch ist die Handhabe 2 vom Benutzer manuell in die Verstellpositionen verstellbar, wodurch die jeweils gewünschten Funktionen im Kraftfahrzeug, beispielsweise mittels entsprechend erzeugter Signale, ausgelöst werden.

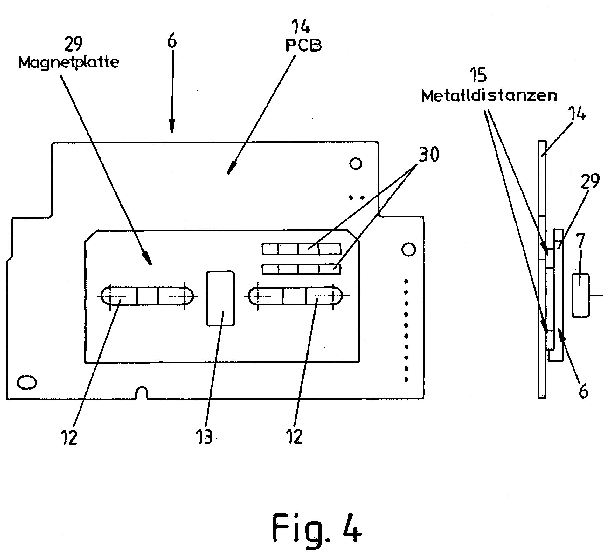

Das Stellglied 1 weist weiterhin ein Mittel zur Erfassung der Verstellpositionen auf. Wie in Fig. 2 zu sehen ist, umfasst das Mittel zur Erfassung der Verstellpositionen einen die Verstellpositionen codierenden Code-Träger 6, wobei der Code-Träger 6 eine eindeutige Codierung für die Verstellpositionen aufweist. Weiter umfasst das Mittel zur Erfassung der Verstellpositionen einen die Codierung ermittelnden Sensor 7, welcher schematisch in Fig. 4 gezeigt ist. Dadurch sind sämtliche Verstellpositionen der Handhabe 2 mittels des einen einzigen Code-Trägers 6 erfassbar.

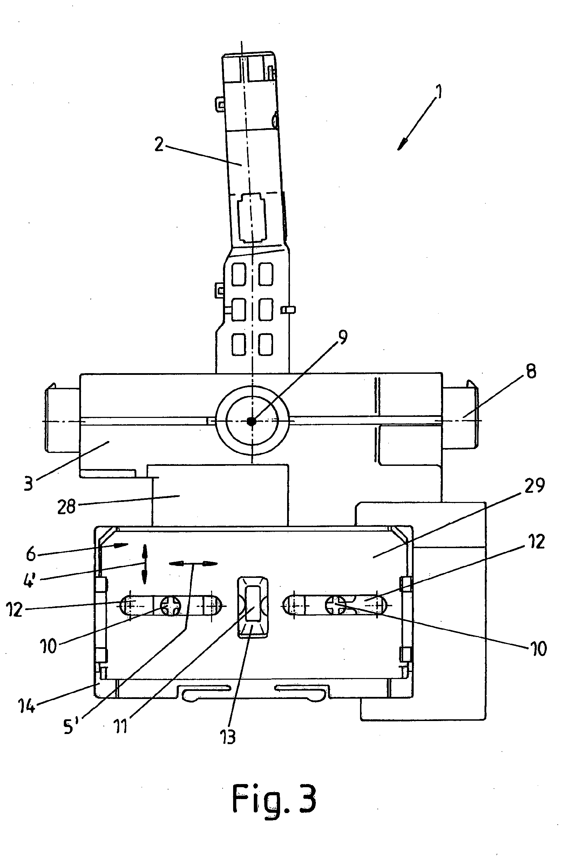

Vorliegend ist die Handhabe 2 mittels Verschwenkung bewegbar ausgestaltet, so dass es sich bei der Handhabe 2 um einen schwenkbaren Wählhebel handelt. Hierzu ist die Handhabe 2, wie in Fig. 3 zu sehen ist, um eine erste Schwenkachse 8 in die erste Schwenkrichtung 4 und um eine zweite Schwenkachse 9 in die zweite Schwenkrichtung 5 verstellbar, wobei die beiden Schwenkrichtungen 4, 5 in etwa senkrecht aufeinander stehen. Und zwar ist der Hebelarm 27 der Handhabe 2 um die Schwenkachse 9 drehbar im Träger 3 gelagert, wie anhand der Fig. 1 zu erkennen ist. Der Träger 3 ist seinerseits drehbar um die Schwenkachse 8 im Gehäuse 25 gelagert. Weiter ist der Träger 3 für die Handhabe 2 als ein Kardangelenk beziehungsweise ein Kreuzgelenk ausgebildet, um die beiden Schwenkrichtungen 4, 5 für die Handhabe 2 zu ermöglichen.

Wie man anhand von Fig. 2 und der Fig. 4 sieht, sind der Code-Träger 6 sowie der Sensor 7 bei Verstellung der Handhabe 2 relativ zueinander bewegbar angeordnet. Vorliegend ist der Code-Träger 6 mittels der Handhabe 2 korrespondierend zur Verstellung der Handhabe 2 bewegbar. Und zwar steht der Code-Träger 6 derart in Zusammenwirkung mit der Handhabe 2, dass der Code-Träger 6 aufgrund der Schwenkbewegung der Handhabe 2 in zwei, senkrecht aufeinander stehenden Richtungen 4', 5' (siehe Fig. 3) linearbeweglich ist. Das Zusammenwirken der Handhabe 2 mit dem Code-Träger 6 ist mittels eines in ein Langloch 12, 13 eingreifenden Stiftes 10, 11 bewirkt. Hierfür ist der eine Stift 11 für die Schwenkrichtung 5 bzw. die Linearrichtung 5' an der Handhabe 2, und zwar gemäß Fig. 1 am Hebelarm 27 der Handhabe 2 angeordnet. Der Stift 11 greift wiederum in das in die eine Richtung 4' verlaufende korrespondierende Langloch 13 des Code-Trägers 6 ein, wie anhand von Fig. 3 zu sehen ist. Wenigstens ein Stift 10 für die Schwenkrichtung 4 bzw. die Linearrichtung 4' ist gemäß Fig. 1 am Träger 3, und zwar genauer an einer Verlängerung 28 am Träger 3, angeordnet. Der Stift 10 greift wiederum in das in die weitere Richtung 5' verlaufende korrespondierende Langloch 12 des Code-Trägers 6 ein, wie man der Fig. 3 entnimmt. Zwecks exakter Führung in die Linearrichtung 4', 5' sind an der Verlängerung 28 zwei Stifte 10 sowie am Code-Träger 6 zwei Langlöcher 12 vorgesehen.

Falls gewünscht kann anstelle des linearbeweglichen Code-Trägers 6 auch der Sensor 7 mittels der Handhabe 2 korrespondierend zur Verstellung der Handhabe 2 bewegbar ausgebildet sein, was jedoch nicht weiter dargestellt ist.

Der Code-Träger 6 umfasst eine magnetische Code-Platte 29, auf der die Verstellposition beispielweise durch entsprechende Magnetspuren 30 codiert sind, wie man der Fig. 4 entnimmt. Folglich besteht die Codierung für die Verstellpositionen aus einer der jeweiligen Verstellposition eindeutig zugeordneten Magnetisierung der Code-Platte 29. Der Sensor 7 besteht aus einem Magnetsensor, beispielsweise aus einem Hallsensor. Selbstverständlich kann auch ein magnetisch-resistiver Sensor, ein induktiven Sensor o. dgl. Verwendung finden.

Der Code-Träger 6 umfasst eine Leiterplatte 14, wobei die magnetische Code-Platte 29 auf der Leiterplatte 14 angeordnet ist, wie in Fig. 4 zu sehen ist. Hierfür ist die Code-Platte 29 mittels Distanzstücke 15 in der Art von Abstandshaltem auf der Leiterplatte 14 befestigt. Die Distanzstücke 15 sind als Metalldistanzen ausgebildet, derart dass die magnetische Code-Platte 29 mittels Magnetkraft durch die Metalldistanzen 15 an der Leiterplatte 14 befestigt ist. Die beispielsweise aus Kunststoff bestehenden Distanzstücke 15 sind mit Metall beschichtet, so dass die Metalldistanzen 15 mittels Löten auf die Leiterplatte 14 aufgebracht werden können. Zum Verlöten bietet sich das SMD(Surface Mounted Device)-Verfahren an.

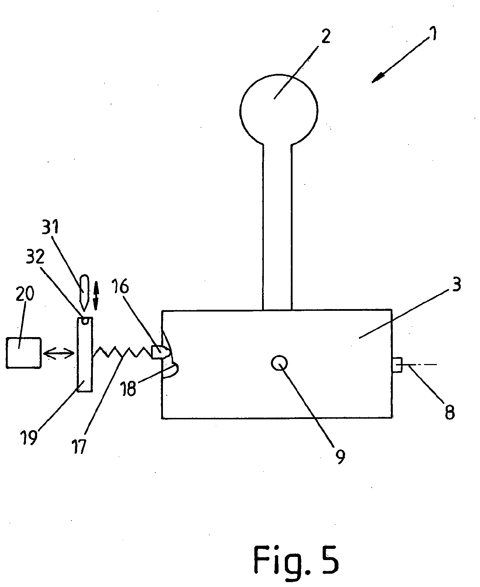

Gemäß einem weiteren Ausführungsbeispiel, das schematisch in Fig. 5 dargestellt ist, ist die Verstellposition bei dem Stellglied 1 als eine Raststellung ausgebildet, derart dass eine Rastkraft in der Verstellposition auf die Handhabe 2 einwirkt. Ebensogut kann die Verstellbewegung als eine Rastbewegung ausgebildet sein, d.h. die Verstellung der Handhabe 2 ist in einer festgelegten Bewegungsgasse zwangsgeführt, derart dass eine Rastkraft während der Verstellbewegung auf die Handhabe 2 einwirkt. Hierzu ist die Rastkraft durch ein gefedertes Druckstück 16 erzeugbar. Das mit einer Druckfeder 17 versehene Druckstück 16 ist mit einer Kulisse 18 am Träger 3 in Zusammenwirkung bringbar. Insbesondere dient dieses Zusammenwirken auch zur Erzeugung einer vom Benutzer fühlbaren Haptik für die Verstellung der Handhabe 2. Zwecks Zusammenwirkung wird das Druckstück 16 mittels eines bewegbaren Adapters 19 zur Zusammenwirkung in die Kulisse 18 gedrückt.

Die Handhabe 2 kann für die Verstellung sperrbar sowie zur Verstellung durch den Benutzer freigebbar ausgestaltet sein. Die Sperrung und/oder Freigabe der Handhabe 2 erfolgt mittels einer am Adapter 19 angeformten, entsprechend korrespondierenden Geometrie 32. Hierzu ist ein ansteuerbares Sperrmittel 31 mit der Geometrie 32 in Wirkverbindung bringbar. Weiter ist der Adapter 19 mittels eines Aktors 20 zur Einwirkung auf das Druckstück 16 bewegbar. Bei dem Aktor 20 kann es sich um einen Elektromagneten, einen Elektromotor o. dgl. handeln.

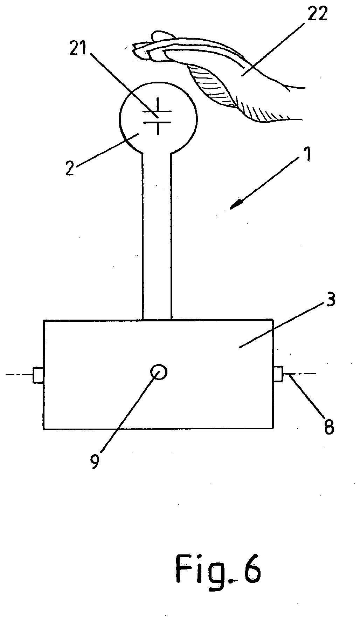

Gemäß einem nochmals weiteren Ausführungsbeispiel, das schematisch in Fig. 6 dargestellt ist, ist die manuell vom Benutzer verstellbare Handhabe 2 für die Bedienung sperrbar sowie zur Bedienung durch den Benutzer freigebbar ausgestaltet. Dabei ist ein Sensor 21 zur Zusammenwirkung mit der Handhabe 2 vorgesehen, derart dass durch Annäherung der Hand 22 des Benutzers an die Handhabe 2 und/oder durch Berühren bzw. Umgreifen der Handhabe 2 durch die Hand 22 des Benutzers der Bedienungswunsch des Benutzers vom Stellglied 1 erkennbar ist. Selbstverständlich kann anstelle der Hand 22 auch ein sonstiges Körperteil des Benutzers, beispielsweise ein Finger des Benutzers, zur Detektierung des Bedienungswunsches herangezogen werden. Daraufhin ist die Handhabe 2 des Stellglieds 1, deren Verstellbarkeit bis dahin gesperrt ist, zur Bedienung durch den Benutzer freigebbar. Falls gewünscht kann die Detektierung des Bedienungswunsches des Benutzers durch den Sensor 21 auch zur Auslösung einer sonstigen Funktionalität im Kraftfahrzeug dienen.

Bei dem Sensor 21 kann es sich um einen kapazitiven Sensor handeln. Der kapazitive Sensor 21 ist in der Handhabe 2 angeordnet. Und zwar in dessen oberen Bereich, der zur Bedienung von der Hand 22 des Benutzers umfasst wird. Hierzu erzeugt der kapazitive Sensor 21 ein elektrisches Feld in der Umgebung der Handhabe 2. Bei Annäherung der Hand 22 an die Handhabe 2 wird das elektrische Feld durch die Hand 22 verändert. Die Veränderung des elektrischen Feldes wird wiederum als eine Kapazitätsänderung vom Sensor 21 detektiert und zur Erkennung des Bedienungswunsches durch den Benutzer ausgewertet.

Selbstverständlich kann auch ein auf einem anderen Wirkprinzip beruhender Näherungssensor Verwendung für die Handhabe 2 finden. Beispielsweise kann es sich bei dem Sensor um einen mittels optischer Strahlung arbeitenden optischen Sensor handeln. Ein solcher Sensor sendet optische Strahlung aus und detektiert den von der Hand 22 reflektierten Anteil dieser optischen Strahlung, um die Annäherung der Hand 22 an die Handhabe 2 und folglich den Bedienungswunsch des Benutzers zu erkennen. Als optische Strahlung eignet sich insbesondere für das menschliche Auge nicht sichtbare Infrarot(IR)-Strahlung. Weiterhin ist als Sensor auch ein induktiver Sensor, der die Veränderung eines elektromagnetischen Feldes im Umfeld der Handhabe 2 durch die Hand 22 des Benutzers detektiert, verwendbar.

Wie bereits anhand der Fig. 5 erläutert ist, kann ein Sperrmittel 31 für die Handhabe 2 vorgesehen sein, derart dass die Verstellung der Handhabe 2 durch das Sperrmittel 31 sperrbar sowie freigebbar ist. Bei Erkennung des Bedienungswunsches des Benutzers erzeugt der Sensor 21 ein Sensorsignal. Dieses Sensorsignal dient dann zur entsprechenden Ansteuerung des Sperrmittels 31 für die Freigabe der Handhabe 2.

Ein derartiges Stellglied 1 lässt sich für einen Gangwahlschalter in Kraftfahrzeugen verwenden. Bei einer solchen Shift-by-Wire-Schaltvorrichtung für das Getriebe im Kraftfahrzeug handelt es sich bei der Handhabe 2 um den Wählhebel für die Shift-by-Wire-Schaltvorrichtung und die Shift-by-Wire-Schaltvorrichtung erzeugt zur Stellung der Handhabe 2 korrespondierende Signale, wobei die Signale zur Steuerung des Getriebes dienen. Die Erfindung ist jedoch nicht auf die beschriebenen und dargestellten Ausführungsbeispiele, deren Elemente auch in beliebiger Kombination miteinander für das Stellglied 1 verwendet werden können, beschränkt. Sie umfasst vielmehr auch alle fachmännischen Weiterbildungen im Rahmen der durch die Patentansprüche definierten Erfindung. Neben Kraftfahrzeuganwendungen kann ein derartiges Stellglied 1 in vorteilhafter Weise auch als Eingabemittel für Computer, Werkzeugmaschinen, Haushaltsgeräte o. dgl. eingesetzt werden.

### Bezugszeichen-Liste:

- 1:: Stellglied
- 2:: Handhabe
- 3:: Träger
- 4, 5:: Richtung / Schwenkrichtung
- 4', 5':: Richtung / Linearrichtung
- 6:: Code-Träger
- 7:: Sensor
- 8:: (erste) Schwenkachse
- 9:: (zweite) Schwenkachse
- 10, 11:: Stift
- 12, 13:: Langloch
- 14:: Leiterplatte
- 15:: Distanzstück / Metalldistanz
- 16:: (gefedertes) Druckstück
- 17:: Druckfeder
- 18:: Kulisse
- 19:: Adapter
- 20:: Aktor
- 21:: (kapazitiver) Sensor
- 22:: Hand
- 25:: Gehäuse
- 26:: Manschette
- 27:: Hebelarm (an der Handhabe)
- 28:: Verlängerung (am Träger)
- 29:: Code-Platte
- 30:: Magnetspur
- 31:: Sperrmittel (für Adapter)
- 32:: Geometrie (am Adapter)

## Patentansprüche

1. Stellglied, insbesondere Schaltvorrichtung zur manuellen Ansteuerung von Funktionen in einem Kraftfahrzeug, mit einer Handhabe (2), wobei die Handhabe (2) an einem Träger (3) derart gelagert ist, dass die Handhabe (2) in zwei verschiedenen Richtungen (4, 5) aus einer neutralen Stellung in zumindest jeweils eine, der jeweiligen Richtung (4, 5) zugeordneten Verstellposition mittels einer Schwenkbewegung verstellbar ist, und mit einem Mittel zur Erfassung der Verstellpositionen, wobei das Mittel zur Erfassung der Verstellpositionen einen Code-Träger (6), der eine Codierung für die Verstellpositionen aufweist, sowie einen die Codierung ermittelnden Sensor (7) umfasst, derart dass sämtliche Verstellpositionen mittels des einen Code-Trägers (6) erfassbar sind, und wobei der Code-Träger (6) derart in Zusammenwirkung mit der Handhabe (2) steht, dass der Code-Träger (6) aufgrund der Schwenkbewegung der Handhabe (2) in zwei Richtungen (4', 5') linearbeweglich ist, **dadurch gekennzeichnet, dass** die Zusammenwirkung der Handhabe (2) mit dem Code-Träger (6) mittels eines in ein Langloch (12, 13) eingreifenden Stiftes (10, 11) bewirkt ist, wobei ein erster Stift (11) an der Handhabe (2) angeordnet ist, wobei der Stift (11) in ein in die eine Richtung (4'), in der der Code-Träger (6) linearbeweglich ist, verlaufendes Langloch (13) des Code-Trägers (6) eingreift, und wobei wenigstens ein weiterer Stift (10) am Träger (3) angeordnet ist, wobei der weitere Stift (10) in ein in die weitere Richtung (5'), in der der Code-Träger (6) linearbeweglich ist, verlaufendes Langloch (12) des Code-Trägers (6) eingreift.

2. Stellglied nach Anspruch 1, **dadurch gekennzeichnet, dass** es sich bei der Handhabe (2) um einen schwenkbaren Wählhebel handelt, dass vorzugsweise die Handhabe (2) um eine erste und eine zweite Schwenkachse (8, 9) in eine erste und eine zweite Schwenkrichtung (4, 5) verstellbar ist, dass weiter vorzugsweise die beiden Schwenkrichtungen (4, 5) in etwa senkrecht aufeinander stehen, und dass noch weiter vorzugsweise der Träger (3) für die Handhabe (2) in der Art eines Kardangelenks und/oder eines Kreuzgelenks ausgebildet ist.

3. Stellglied nach Anspruch 1 oder 2, **dadurch gekennzeichnet, dass** bei Verstellung der Handhabe (2) der Code-Träger (6) sowie der Sensor (7) relativ zueinander bewegbar sind, und dass vorzugsweise der Code-Träger (6) und/oder der Sensor (7) mittels der Handhabe (2) korrespondierend zur Verstellung der Handhabe (2) bewegbar ist.

4. Stellglied nach Anspruch 1, 2 oder 3, **dadurch gekennzeichnet, dass** die beiden Richtungen (4', 5'), in denen der Code-Träger (6) linearbeweglich ist, senkrecht aufeinander stehen.

5. Stellglied nach einem der Ansprüche 1 bis 4, **dadurch gekennzeichnet, dass** der erste Stift (11) an der Handhabe (2) an einem Hebelarm (27) der Handhabe (2) angeordnet ist, und dass vorzugsweise der weitere Stift (10) am Träger (3) an einer Verlängerung (28) am Träger (3) angeordnet ist.

6. Stellglied nach einem der Ansprüche 1 bis 5, **dadurch gekennzeichnet, dass** der Code-Träger (6) eine magnetische Code-Platte (29) umfasst sowie der Sensor (7) aus einem Magnetsensor, insbesondere einem Hallsensor, einem magnetisch-resistiven Sensor, einem induktiven Sensor o. dgl., besteht, wobei vorzugsweise die Codierung für die Verstellpositionen aus einer der jeweiligen Verstellposition zugeordneten Magnetisierung der Code-Platte (29) besteht.

7. Stellglied nach einem der Ansprüche 1 bis 6, **dadurch gekennzeichnet, dass** der Code-Träger (6) eine Leiterplatte (14) umfasst, und dass vorzugsweise die magnetische Code-Platte (29) auf der Leiterplatte (14) angeordnet ist.

8. Stellglied nach einem der Ansprüche 1 bis 7, **dadurch gekennzeichnet, dass** die Code-Platte (29) mittels Distanzstücke (15) in der Art von Abstandshaltern auf der Leiterplatte (14) befestigt ist, und dass vorzugsweise die Distanzstücke (15) als, insbesondere beschichtete, Metalldistanzen ausgebildet sind, derart dass die Code-Platte (29) magnetisch an der Leiterplatte (14) befestigt ist.

9. Stellglied nach einem der Ansprüche 1 bis 8, **dadurch gekennzeichnet, dass** die Distanzstücke (15) im SMD-Verfahren auf die Leiterplatte (14) aufgebracht sind.

10. Stellglied nach einem der Ansprüche 1 bis 9, **dadurch gekennzeichnet, dass** die Verstellbewegung als Rastbewegung und/oder die Verstellposition als Raststellung ausgebildet ist, derart dass eine Rastkraft während der Verstellbewegung und/oder in der Verstellposition auf die Handhabe (2) einwirkt, wobei insbesondere die Rastkraft durch ein gefedertes Druckstück (16) erzeugbar ist.

11. Stellglied nach Anspruch 10, **dadurch gekennzeichnet, dass** das gefederte Druckstück (16), insbesondere zur Erzeugung einer Haptik für die Verstellung der Handhabe (2), mit einer Kulisse (18) in Zusammenwirkung bringbar ist, und dass vorzugsweise das gefederte Druckstück (16) mittels eines bewegbaren Adapters (19) zur Zusammenwirkung in die Kulisse (18) gedrückt wird.

12. Stellglied nach Anspruch 10 oder 11, **dadurch gekennzeichnet, dass** die Handhabe (2) für die Verstellung sperrbar sowie zur Verstellung freigebbar ist, dass vorzugsweise die Sperrung und/oder die Freigabe der Handhabe (2) mittels einer am Adapter (19) angeformten Geometrie (32) erfolgt, und dass weiter vorzugsweise ein ansteuerbares Sperrmittel (31) mit der Geometrie (32) in Wirkverbindung bringbar ist.

13. Stellglied nach einem der Ansprüche 10 bis 12, **dadurch gekennzeichnet, dass** der Adapter (19) mittels eines Aktors (20) zur Einwirkung auf das Druckstück (16) bewegbar ist.

14. Stellglied nach einem der Ansprüche 10 bis 13, **dadurch gekennzeichnet, dass** es sich bei dem Aktor (20) um einen Elektromotor, einen Elektromagneten o. dgl. handelt.

15. Stellglied nach einem der Ansprüche 1 bis 14, **dadurch gekennzeichnet, dass** die manuell von einem Benutzer verstellbare Handhabe (2) für die Bedienung sperrbar sowie zur Bedienung durch den Benutzer freigebbar ist, wobei ein Sensor (21) zur Zusammenwirkung mit der Handhabe (2) vorgesehen ist, derart dass durch Annäherung an die Handhabe (2) und/oder Berühren, insbesondere Umgreifen, der Handhabe (2) durch den Benutzer, insbesondere durch dessen Hand, der Bedienungswunsch des Benutzers erkennbar sowie die Handhabe (2) zur Bedienung freigebbar ist und/oder eine sonstige Funktionalität im Kraftfahrzeug auslösbar ist.

16. Stellglied nach Anspruch 15, **dadurch gekennzeichnet, dass** es sich bei dem Sensor (21) um einen kapazitiven Sensor handelt.

17. Stellglied nach Anspruch 15 oder 16, **dadurch gekennzeichnet, dass** es sich bei dem Sensor (21) um einen mittels optischer Strahlung, insbesondere mittels Infrarot(IR)-Strahlung, arbeitenden optischen Sensor, einen induktiven Sensor o. dgl. handelt.

18. Stellglied nach einem der Ansprüche 15 bis 17, **dadurch gekennzeichnet, dass** ein Sperrmittel (31) für die Handhabe (2) vorgesehen ist, derart dass deren Verstellung durch das Sperrmittel (31) sperrbar und/oder freigebbar ist, dass vorzugsweise der Sensor (21) bei Erkennung des Bedienungswunsches des Benutzers ein Sensorsignal erzeugt, und dass weiter vorzugsweise das Sensorsignal zur Ansteuerung des Sperrmittels (31) für die Freigabe der Handhabe (2) dient.

## Claims

1. An actuator, in particular a switching device for the manual actuation of functions in a motor vehicle, having a handle (2), wherein the handle (2) is mounted on a carrier (3) such that the handle (2) is adjustable in two different directions (4, 5) from a neutral position into at least one adjustment position assigned to the respective direction (4, 5), by means of a pivoting movement, and having a means for detecting the adjustment positions, wherein the means for detecting the adjustment positions comprises a code carrier (6), which has an encoding for the adjustment positions, and a sensor (7) detecting the encoding, such that all adjustment positions can be detected by means of the one code carrier (6), and wherein the code carrier (6) interacts in such a way with the handle (2) that the code carrier (6) is linearly movable in two directions (4', 5') due to the pivoting movement of the handle (2), **characterized in that** the interaction of the handle (2) with the code carrier (6) is effected by means of a pin (10, 11) engaging in a slot (12, 13), a first pin (11) being arranged on the handle (2), wherein the pin (11) engages in a slot (13) of the code carrier (6), said slot running in one of the directions (4') in which the code carrier (6) is linearly movable, and wherein at least one further pin (10) is arranged on the carrier (3), wherein the further pin (10) engages in a slot (12) of the code carrier (6), said slot running in the other direction (5') in which the code carrier (6) is linearly movable.

2. The actuator according to claim 1, **characterized in that** the handle (2) is a pivotable selector lever, that preferably the handle (2) is adjustable about a first and a second pivot axis (8, 9) in a first and a second pivoting direction (4, 5), that more preferably, the two pivoting directions (4, 5) are approximately perpendicular to each other, and still more preferably that the carrier (3) for the handle (2) is designed in the manner of a universal joint and/or a Cardan joint.

3. The actuator according to claim 1 or 2, **characterized in that**, upon adjustment of the handle (2), the code carrier (6) and the sensor (7) are movable relative to each other, and that preferably the code carrier (6) and/or the sensor (7) is movable by means of the handle (2) corresponding to the adjustment of the handle (2).

4. The actuator according to claim 1, 2 or 3, **characterized in that** the two directions (4', 5'), in which the code carrier (6) is linearly movable, are perpendicular to each other.

5. The actuator according to one of claims 1 to 4, **characterized in that** the first pin (11) is arranged on the handle (2) on a lever arm (27) of the handle (2), and that preferably the further pin (10) is arranged on the carrier (3) on an extension (28) on the carrier (3).

6. The actuator according to one of claims 1 to 5, **characterized in that** the code carrier (6) comprises a magnetic code plate (29) and the sensor (7) consists of a magnetic sensor, in particular a Hall sensor, a magnetoresistive sensor, an inductive sensor or the like, wherein preferably the encoding for the adjustment positions consists of a magnetization of the code plate (29) associated with the respective adjustment position.

7. The actuator according to one of claims 1 to 6, **characterized in that** the code carrier (6) comprises a printed circuit board (14), and that preferably the magnetic code plate (29) is arranged on the printed circuit board (14).

8. The actuator according to one of claims 1 to 7, **characterized in that** the code plate (29) is attached by means of spacers (15) in the manner of separators on the printed circuit board (14), and that preferably the spacers (15) are designed as, in particular coated, metal spacings, such that the code plate (29) is magnetically attached to the printed circuit board (14).

9. The actuator according to one of claims 1 to 8, **characterized in that** the spacers (15) are applied to the printed circuit board (14) using the SMD method.

10. The actuator according to one of claims 1 to 9, **characterized in that** the adjustment movement is designed as a latching movement and/or the adjustment position as a latching position, such that a latching force acts on the handle (2) during the adjustment movement and/or in the adjustment position, wherein in particular the latching force can be generated by a spring-loaded pressure piece (16).

11. The actuator according to claim 10, **characterized in that** the spring-loaded pressure piece (16), in particular for generating a haptic for the adjustment of the handle (2), can be brought into interaction with a link (18), and that preferably the spring-loaded pressure piece (16) is pressed by a movable adapter (19) for interaction in the link (18).

12. The actuator according to claim 10 or 11, **characterized in that** the handle (2) is lockable for the adjustment and releasable for adjustment, that preferably the locking and/or release of the handle (2) occurs by means of a geometry (32) integrally formed on the adapter (19), and that further preferably a controllable locking means (31) can be operatively connected with the geometry (32).

13. The actuator according to one of claims 10 to 12, **characterized in that** the adapter (19) is movable by means of an actuating element (20) for acting on the pressure piece (16).

14. The actuator according to one of claims 10 to 13, **characterized in that** the actuating element (20) is an electric motor, an electromagnet or the like.

15. The actuator according to one of claims 1 to 14, **characterized in that** the handle (2), which is manually adjustable by a user, is lockable for operation and releasable for operation by the user, wherein a sensor (21) is provided for interaction with the handle (2), such that when the user approaches the handle (2) and/or touches, in particular encompasses, the handle (2), in particular using his hand, the user's operation request is recognizable and the handle (2) is releasable for operation and/or a different functionality in the motor vehicle can be triggered.

16. The actuator according to claim 15, **characterized in that** the sensor (21) is a capacitive sensor.

17. The actuator according to claim 15 or 16, **characterized in that** the sensor (21) is a sensor operating by means of optical radiation, in particular by means of infrared (IR) radiation, an inductive sensor or the like.

18. The actuator according to one of claims 15 to 17, **characterized in that** a locking means (31) is provided for the handle (2), such that its adjustment by the locking means (31) can be locked and/or released, **in that** preferably the sensor (21) generates a sensor signal upon detection of the user's operation request, and **in that** more preferably the sensor signal for activating the locking means (31) is used for the release of the handle (2).

## Revendications

1. Organe de réglage, en particulier dispositif de commutation destiné à la commande manuelle de fonctions dans un véhicule automobile, comprenant une manette (2), la manette (2) étant montée sur un support (3) de sorte que la manette (2) puisse être déplacée dans deux directions différentes (4, 5) à partir d'une position neutre dans au moins une position de réglage associée à la direction respective (4, 5) au moyen d'un mouvement de pivotement, et un moyen de détection des positions de réglage, le moyen de détection des positions de réglage comprenant un support de code (6), comprenant un codage pour les positions de réglage et un capteur (7) déterminant le codage, de sorte que toutes les positions de réglage puissent être détectées au moyen du support de code (6) et le support de code (6) coopérant avec la manette (2) de sorte que le support de code (6) soit mobile linéairement dans deux directions (4', 5') en raison du mouvement de pivotement de la manette (2), **caractérisé en ce que en ce que** la coopération de la manette (2) avec le support de code (6) est réalisée au moyen d'une broche (10, 11) s'engageant dans un trou oblong (12, 13), une première broche (11) étant agencée sur la manette (2), la broche (11) venant en prise dans un trou oblong (13) du support de code (6) s'étendant dans la direction (4') dans laquelle le support de code (6) est mobile linéairement et au moins une autre broche (10) étant agencée sur le support (3), l'autre broche (10) venant en prise dans le trou oblong (12) du support de code (6) s'étendant dans l'autre direction (5'), dans laquelle le support de code (6) est mobile linéairement.

2. Organe de réglage selon la revendication 1, **caractérisé en ce que** la manette (2) est un levier sélecteur pivotant, **en ce que**, de préférence, la manette (2) peut être réglée autour d'un premier et d'un second axe de pivotement (8, 9) dans une première et une seconde direction de pivotement (4, 5), **en ce que**, de préférence encore, les deux directions de pivotement (4, 5) sont approximativement perpendiculaires l'une à l'autre et **en ce que**, de préférence encore, le support (3) pour la manette (2) est conçu à la manière d'un joint de cardan et/ou d'un joint à croisillon.

3. Organe de réglage selon la revendication 1 ou 2, **caractérisé en ce que** lors du réglage de la manette (2), le support de code (6) ainsi que le capteur (7) sont mobiles l'un par rapport à l'autre et **en ce que** de préférence le support de code (6) et/ou le capteur (7) sont mobiles au moyen de la manette (2) d'une manière correspondant au réglage de la manette (2).

4. Organe de réglage selon la revendication 1, 2 ou 3, **caractérisé en ce que** les deux directions (4', 5') dans lesquelles le support de code (6) est mobile linéairement, sont perpendiculaires l'une à l'autre.

5. Organe de réglage selon l'une des revendications 1 à 4, **caractérisé en ce que** la première broche (11) est agencée sur la manette (2) sur un bras de levier (27) de la manette (2) et **en ce que** de préférence l'autre broche (10) est agencée sur le support (3) sur un prolongement (28) du support (3).

6. Organe de réglage selon l'une des revendications 1 à 5, **caractérisé en ce que** le support de code (6) comprend une plaque de code magnétique (29) et le capteur (7) est constitué d'un capteur magnétique, notamment d'un capteur à effet Hall, d'un capteur magnétorésistif, d'un capteur inductif ou similaire, de préférence, le codage pour les positions de réglage étant constitué d'une aimantation associée à la position de réglage respective de la plaque de code (29).

7. Organe de réglage selon l'une des revendications 1 à 6, **caractérisé en ce que** le support de code (6) comprend une carte de circuit imprimé (14) et **en ce que** de préférence la plaque de code magnétique (29) est agencée sur la carte de circuit imprimé (14).

8. Organe de réglage selon l'une des revendications 1 à 7, **caractérisé en ce que** la plaque de code (29) est fixée au moyen d'entretoises (15) à la manière d'écarteurs sur la carte de circuit imprimé (14) et **en ce que** de préférence les entretoises (15) sont formées notamment comme des espacements métalliques revêtus, de telle sorte que la plaque de code (29) soit fixée magnétiquement à la carte de circuit imprimé (14).

9. Organe de réglage selon l'une des revendications 1 à 8, **caractérisé en ce que** les entretoises (15) sont appliquées sur la carte de circuit imprimé (14) selon un procédé CMS.

10. Organe de réglage selon l'une des revendications 1 à 9, **caractérisé en ce que** le mouvement de réglage est conçu comme un mouvement d'encliquetage et/ou la position de réglage est conçue comme une position d'encliquetage, de sorte qu'un effort d'encliquetage agisse sur la manette (2) lors du mouvement de réglage et/ou dans la position de réglage, la force d'encliquetage pouvant notamment être produite par une pièce de pression à ressort (16).

11. Organe de réglage selon la revendication 10, **caractérisé en ce que** la pièce de pression à ressort (16) peut être amenée à coopérer avec une coulisse (18), en particulier pour générer une sensation de réglage lors du réglage de la manette (2) et **en ce que** de préférence la pièce de pression à ressort (16) est pressée par un adaptateur mobile (19) pour coopérer dans la coulisse (18).

12. Organe de réglage selon la revendication 10 ou 11, **caractérisé en ce que** la manette (2) peut être verrouillée pour le réglage et peut être libérée pour le réglage, **en ce que** de préférence le verrouillage et/ou le déverrouillage de la manette (2) sont effectués au moyen d'une géométrie (32) formée sur l'adaptateur (19) et **en ce que**, de préférence, un moyen de verrouillage commandable (31) peut être placé en relation fonctionnelle avec la géométrie (32).

13. Organe de réglage selon l'une des revendications 10 à 12, **caractérisé en ce que** l'adaptateur (19) est mobile au moyen d'un actionneur (20) destiné à agir sur la pièce de pression (16).

14. Organe de réglage selon une des revendications 10 à 13, **caractérisé en ce que** l'actionneur (20) est un moteur électrique, d'un électro-aimant ou similaire.

15. Organe de réglage selon l'une des revendications 1 à 14, **caractérisé en ce que** la manette (2) réglable manuellement par un utilisateur, peut être verrouillée pour l'opération et libérée pour l'opération par l'utilisateur, un capteur (21) servant à coopérer avec la manette (2) étant prévu, de sorte que lorsque l'utilisateur s'approche de la manette (2) et/ou touche, notamment saisit, la manette (2), en particulier avec sa main, la demande d'opération de l'utilisateur soit reconnaissable et que la manette (2) soit libérable pour l'opération et/ou une autre fonctionnalité du véhicule puisse être déclenchée.

16. Organe de réglage selon la revendication 15, **caractérisé en ce que** le capteur (21) est un capteur capacitif.

17. Organe de réglage selon la revendication 15 ou 16, **caractérisé en ce que** le capteur (21) est un capteur optique fonctionnant au moyen d'un rayonnement optique, en particulier d'un rayonnement infrarouge (IR), d'un capteur inductif ou analogue.

18. Organe de réglage selon l'une des revendications 15 à 17, **caractérisé en ce qu'**un moyen de verrouillage (31) de la manette (2) est prévu, de sorte que son réglage puisse être bloqué et/ou libéré par le moyen de verrouillage (31), **en ce que** de préférence le capteur (21) produit un signal de capteur lors de la reconnaissance de la demande d'opération de l'utilisateur et **en ce que**, de préférence encore, le signal de capteur sert à commander le moyen de verrouillage (31) pour la libération de la manette (2).
